# EUROPEAN PATENT APPLICATION

(11) **EP 4 651 661 A2**
(43) Date of publication of application: **19.11.2025**
(21) Application number: 25176361.1
(22) Date of filing: 14.05.2025
(51) Int. Cl.: H05K 7/20

(54) **DOOR WITH LOUVERS TO REDUCE ACOUSTIC AND EMC NOISE AND TO PROVIDE TAMPER DETECTION**

(30) Priority: 15.05.2024 US 202418665234
(71) Applicant: Google LLC, Mountain View, CA 94043 (US)
(72) Inventor: KHALILI, Sadegh, Mountain View, California, 94043 (US); SONI, Gaurav, Mountain View, California, 94043 (US); IYENGAR, Madhusudan K., Mountain View, California, 94043 (US)
(74) Representative: Betten & Resch

(57) **Abstract**

A door for supplying air to a data center enclosure includes a frame mounted to the door and a plurality of louvers positioned in the frame such that the plurality of louvers extends at least partially across an opening defined through the door. Each louver of the plurality of louvers includes a sound absorbing core at least partially surrounded by a sound reflecting cover. Each louver can be modulated by a control system to direct air into the data center while also dampening noise levels inside the data center. The control system is electronically connected to a display to provide real time information pertaining to environmental conditions within the data center.

## Description

### BACKGROUND

Data centers include racks of electrical components that are spaced apart from each other to form aisles. Such racks include heat-generating electrical components, like chips, hard drives, power supplies, etc. If enough heat is generated, the electrical components can be damaged if the heat is not properly dissipated away from the rack.

Typically, data centers are cooled using air-cooling methods and systems. Many data centers use large fans that distribute air down the aisles between the racks such that the air can absorb the heat generated from the electrical components. In addition to the large fans, the various heat-generating electrical components in the data center are often equipped with dedicated fans for air-cooling.

Cooling fans, whether the larger fans for distributing air in the data center or smaller fans cooling components within the data centers are often loud and require operators in the vicinity of the fans to wear hearing protection. Because of the sensitive nature of the electrical components within the data centers, vibrations from the fans can also be absorbed by the electrical components, thereby potentially damaging the components and racks. Data centers are also designed to comply with electromagnetic compatibility requirements. Such requirements limit the size of air pathways around the racks, thereby limiting the cooling performance of any air-cooling systems.

### BRIEF SUMMARY

Aspects of the disclosure relate to a louver assembly including one or more louvers mounted to a door frame. Each louver is capable of both absorbing and deflecting noise to lower the overall noise levels within the data center. The louver assembly is electronically connected to a control system that receives and analyzes data from various sensors positioned within a data center rack and/or in close vicinity of the server rack, e.g., mounted on the frame of the data center rack or rack doors. Based on the sensed data, the control system modulates the louvers of the louver assembly to control both a rate of cooling airflow and a permissible noise level within the data center. The control system is connected to a display that indicates various environmental conditions of the data center as well as parameters of the louver assembly.

According to further aspects of the disclosure, a door for supplying air to a data center enclosure includes a frame mounted to the door and a plurality of louvers positioned in the frame such that the plurality of louvers extends at least partially across an opening defined through the door. Each louver of the plurality of louvers includes a sound absorbing core at least partially surrounded by a sound reflecting cover. Each louver can be modulated by a control system to direct air into the data center while also dampening noise levels inside the data center. The control system is electronically connected to a display to provide real time information pertaining to environmental conditions within the data center.

### BRIEF DESCRIPTION OF THE DRAWINGS

FIG. 1 is a partially exploded perspective view of a louver assembly according to aspects of the disclosure.
FIG. 2 is a block diagram of an example environment of a control system implemented with a louver system according to aspects of the disclosure.
FIG. 3 is a perspective view of a louver of the louver assembly of FIG. 1.
FIG. 4 is a top view of a louver according to aspects of the disclosure.
FIG. 5 is a perspective view of the louver of FIG. 4.
FIG. 6 is another perspective view of the louver of FIG. 4.
FIG. 7 is a perspective view of a louver according to aspects of the disclosure.
FIG. 8 is a top view of the louver of FIG. 7.
FIG. 9 is a perspective view of a louver according to aspects of the disclosure.
FIG. 10 is a side view of the louver of FIG. 9.
FIG. 11 is a side view of a louver according to aspects of the disclosure.
FIG. 12 is a perspective view of the louver of FIG. 11.
FIG. 13 is a side view of the louver assembly of FIG. 1 implemented with an electrical component of a data center.
FIG. 14 is another side view of the louver assembly and electrical component of FIG. 13.
FIG. 15 is a side view of a louver oriented at an attack angle θ according to aspects of the disclosure.
FIG. 16 is a side view of a louver assembly implemented with a rack of a data center according to aspects of the disclosure.
FIG. 17 is an exploded perspective view of a louver assembly implemented with a fan assembly according to aspects of the disclosure.
FIG. 18 is a side view of the louver assembly implemented with a fan assembly of FIG. 16.
FIG. 19 is a side view of a louver assembly implemented with a fan assembly and a rack of a data center according to aspects of the disclosure.
FIG. 20 is a perspective view of a louver assembly according to aspects of the disclosure.
FIG. 21 is a side view of a louver assembly implemented with a rack of a data center according to aspects of the disclosure.
FIG. 22 is a perspective view of a louver assembly according to aspects of the disclosure.
FIG. 23 is a perspective view of a louver assembly according to aspects of the disclosure.
FIG. 24 is a side view of a tamper detection mechanism implemented with a louver assembly according to aspects of the disclosure.
FIG. 25 is a side view of another tamper detection mechanism implemented with a louver assembly according to aspects of the disclosure.
FIG. 26 is a perspective view of a sound dampening plate according to aspects of the disclosure.
FIG. 27 is another perspective view of the sound dampening plate of FIG. 26.
FIG. 28 is a side cross-sectional view of the sound dampening plate of FIG. 26.
FIG. 29 is a partially cut-away perspective view of the sound dampening plate of FIG. 26.
FIG. 30 is a flowchart of an example process for implementing a louver assembly according to aspects of the disclosure.
FIG. 31 is a flowchart of an example process for implementing a louver assembly according to aspects of the disclosure.
FIG. 32 is a flowchart of an example process for implementing a louver assembly according to aspects of the disclosure.

### DETAILED DESCRIPTION

The louver assembly and methods described herein may be broadly implemented with heat-producing devices. In some examples, the cooling system and methods may be implemented with doors of data center racks. The disclosed cooling systems and methods may be implemented with other implementations, such as windows, openings for HVAC units, and the like.

The louver assembly and methods described herein allow for air flow control, noise level control, and electromagnetic interference (EMI) control all from the same assembly. Particularly, the louver assembly includes one or more louvers that are pivotably mounted within a door frame. Each louver has a sound absorbing core at least partially surrounded by a sound reflecting cover. Depending on the angular orientation of the louver relative to the door frame, the environmental conditions within the rack can be controlled.

The louver assembly is electronically connected to a control system. The control system receives inputs from various sensors positioned within or near the rack, the inputs relating to temperature, pressure, noise, and the like. Based on these inputs, the control system dynamically modulates the angular orientation of the louvers to direct air flow into the rack at a desired flow rate. Thus, the temperature within the data center, which is correlated to the performance of the electronic equipment within the data center, and the noise within the data center, which is correlated to employee comfort as well as electronic equipment performance, are controlled without the need for human intervention.

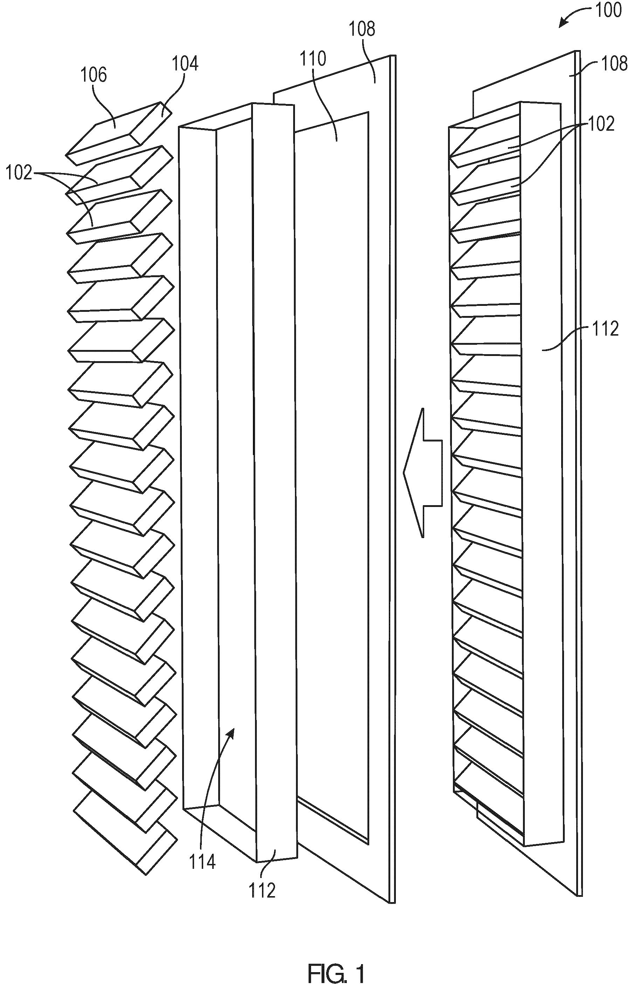

FIG. 1 illustrates a first louver assembly 100 implemented with a door 108 of a data center rack enclosure. Louver assembly 100 includes multiple louvers 102 horizontally mounted within an opening 114 of a frame 112. Louvers 102 can be curved or flat slats, which may be uniformly spaced from one another and mounted onto a frame. In some examples and as described herein, the louvers 102 may be adjustable in angle and/or in distance from one another. Frame 112 is then mounted to a door 108. An optional mesh screen 110 is positioned within an opening of the door. Louvers 102 may be modulated to direct air flow in a desired direction, or to increase air flow, thereby improving the cooling capacity or reducing noise level outside of the rack. When the louvers 102 are modulated to increase the angle of attack, air flow is reduced, but noise reduction effectiveness is increased. When the louvers 102 are modulated to reduce the angle of attack, the air flow is less impeded, increasing air flow, but noise reduction effectiveness is decreased.

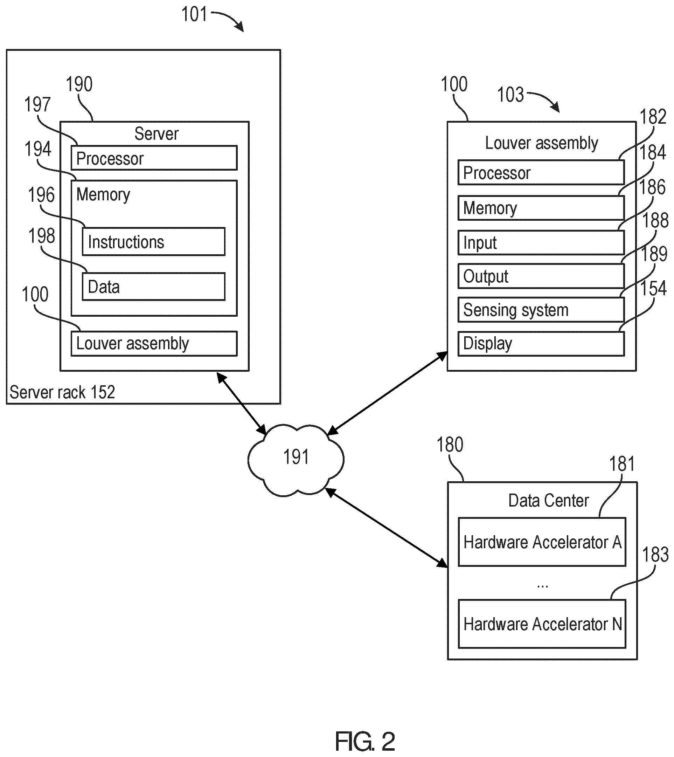

FIG. 2 depicts a block diagram of an example environment 101 for implementing a louver control system 103 that controls a louver assembly 100 within a data center rack 152. The louver control system 103 can be implemented on one or more devices having one or more processors in one or more locations, such as in server 190. Although shown as separate from the data center rack 152 in FIG. 2, in some examples the server 190 is implemented inside the data center 180. The louver assembly 100 and the server 190 can be communicatively coupled to one or more storage devices over a network 191. Particularly, the server 190 can include the components described herein while being within the broader assembly of the server rack that includes the louver assembly 100. The storage devices can be a combination of volatile and non-volatile memory and can be at the same or different physical locations than the computing devices. For example, the storage devices can include any type of non-transitory computer readable medium capable of storing information, such as a hard-drive, solid state drive, tape drive, optical storage, memory card, ROM, RAM, DVD, CD-ROM, write-capable, and read-only memories.

The server 190 can include one or more processors 197 and memory 194. The memory 194 can store information accessible by the processors 197, including instructions 196 that can be executed by the processors 197. The memory 194 can also include data 198 that can be retrieved, manipulated, or stored by the processors 197. The memory 194 can be a type of non-transitory computer readable medium capable of storing information accessible by the processors, such as volatile and non-volatile memory. The processors 197 can include one or more central processing units (CPUs), graphic processing units (GPUs), field-programmable gate arrays (FPGAs), and/or application-specific integrated circuits (ASICs), such as tensor processing units (TPUs).

The instructions 196 can include one or more instructions that, when executed by the processors 197, cause the one or more processors 197 to perform actions defined by the instructions 196. The instructions 196 can be stored in object code format for direct processing by the processors 197, or in other formats including interpretable scripts or collections of independent source code modules that are interpreted on demand or compiled in advance. The instructions 196 can include instructions for implementing a louver control system 103, which can correspond to the louver assembly 100 of FIG. 1. The louver control system 103 can be executed using the processors 197, and/or using other processors remotely located from the server computing device.

The data 198 can be retrieved, stored, or modified by the processors in accordance with the instructions 196. The data 198 can be stored in computer registers, in a relational or non-relational database as a table having a plurality of different fields and records, or as JSON, YAML, proto, or XML documents. The data 198 can also be formatted in a computer-readable format such as, but not limited to, binary values, ASCII, or Unicode. Moreover, the data 198 can include information sufficient to identify relevant information, such as numbers, descriptive text, proprietary codes, pointers, references to data stored in other memories, including other network locations, or information that is used by a function to calculate relevant data.

The server 190 can be configured to transmit data to the louver assembly 100, and the louver assembly 100 can be configured to display at least a portion of the received data on a display 154 implemented as part of the user output 188. The user output 188 can also be used for displaying an interface between the louver assembly 100 and the server 190. The user output 188 can alternatively or additionally include one or more speakers, transducers or other audio outputs, a haptic interface or other tactile feedback that provides non-visual and non-audible information to the platform user of the client computing device. The louver assembly 100 further includes a processor 152 and a memory 184 that function similarly to processor 197 and memory 194. Louver assembly 100 may further receive user inputs 186 based on conditions determined from a sensing system 189.

Although FIG. 2 illustrates the processors and the memories as being within the computing devices, components described herein can include multiple processors and memories that can operate in different physical locations and not within the same computing device. For example, some of the instructions and the data can be stored on a removable SD card and others within a read-only computer chip. Some or all of the instructions and data can be stored in a location physically remote from, yet still accessible by, the processors. Similarly, the processors can include a collection of processors that can perform concurrent and/or sequential operation. The computing devices can each include one or more internal clocks providing timing information, which can be used for time measurement for operations and programs run by the computing devices.

The server 190 can be connected over the network 191 to a data center 180 housing any number of hardware accelerators, such as hardware accelerator 181 and hardware accelerator 183. The data center 180 can be one of multiple data centers or other facilities in which various types of computing devices, such as hardware accelerators, are located. Louver assembly 100 can be implemented in data center 180, for example as part of a server rack assembly described herein.

The devices and the data center can be capable of direct and indirect communication over the network 191. For example, using a network socket, the client computing device can connect to a service operating in the data center through an Internet protocol. The devices can set up listening sockets that may accept an initiating connection for sending and receiving information. The network itself can include various configurations and protocols including the Internet, World Wide Web, intranets, virtual private networks, wide area networks, local networks, and private networks using communication protocols proprietary to one or more companies. The network 191 can support a variety of short- and long-range connections. The short- and long-range connections may be made over different bandwidths, such as 2.402 GHz to 2.480 GHz, commonly associated with the Bluetooth^{®} standard, 2.4 GHz and 5 GHz, commonly associated with the Wi-Fi^{®} communication protocol, or with a variety of communication standards, such as the LTE^{®} standard for wireless broadband communication. The network 191, in addition or alternatively, can also support wired connections between the devices and the data center, including over various types of Ethernet connection.

Although a single server 190, louver assembly 100, and data center 180 are shown in FIG. 2, it is understood that the aspects of the disclosure can be implemented according to a variety of different configurations and quantities of computing devices, including in paradigms for sequential or parallel processing, or over a distributed network of multiple devices. In some implementations, aspects of the disclosure can be performed on a single device connected to hardware accelerators configured for processing optimization models, and any combination thereof.

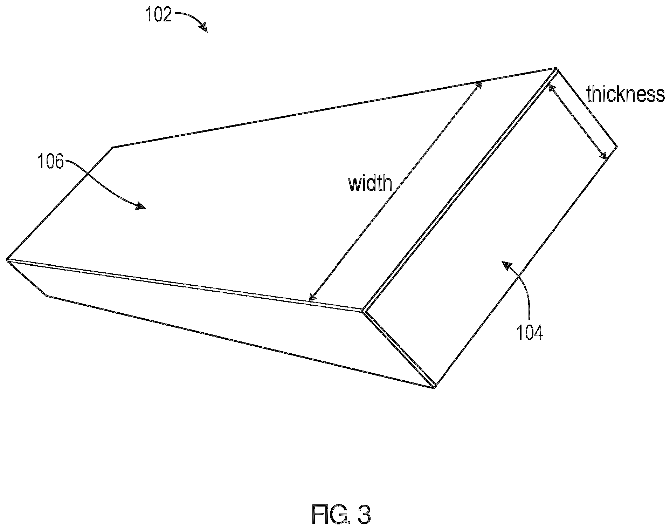

Continuing with the example of FIG. 1 and also referring to the example of FIG. 3, each louver 102 includes a sound absorbing core 104 at least partially surrounded by a sound reflecting cover 106. The sound absorbing core 104 can be acoustic foam and the sound reflecting cover 106 can be an aluminum sheet that covers two sides of the rectangular prismatic core 104. Core 104 is not limited to foam, and may be other sound absorbing materials, for example soft and porous materials, such as foam, fiberglass, wool, and the like. Likewise, sound reflecting cover 106 is not limited to aluminum, and may be other sound reflecting materials, such as glass, and various metals, such as steel. Sound reflecting cover 106 is grounded to provide at least partial electromagnetic interference shielding.

Frame 112 and door 108 may be implemented as standard exterior hinged-type doors, but may also be implemented with windows, interior doors, and the like. In different examples, frame 112 is formed of either a sound absorbing or a sound reflecting materials. Frame 112 may further have various ridges, tracks, or the like to aid in inserting individual louvers 102 into frame 112 at a desired pitch. Alternatively, each louver 112 may be individually adjusted by manually pivoting each louver, by using a rotation aid such as a thumb screw extending through the sides of frame 112, or other similar methods. Louvers 102 may be integrally formed with frame 112 and door 108 such that they are not movable relative to frame 112 and door 108.

Louver assembly 100 includes eighteen louvers, each louver 102 positioned at a distance away from an adjacent louver 102 and at an angle of attack to allow air to flow between gaps defined between adjacent louvers. A system for determining the angle of attack is described herein below. Each of louvers 102 may be attached to frame 112 via fasteners such as screws, bolts, and the like, or may be attached via adhesives and other connection methods. In some examples, the louvers 102 may also be slotted into grooves or otherwise mechanically connected with the frame 112 without fasteners. The number, size, type, and spacing between louvers 102 may be modified depending on the particular implementation.

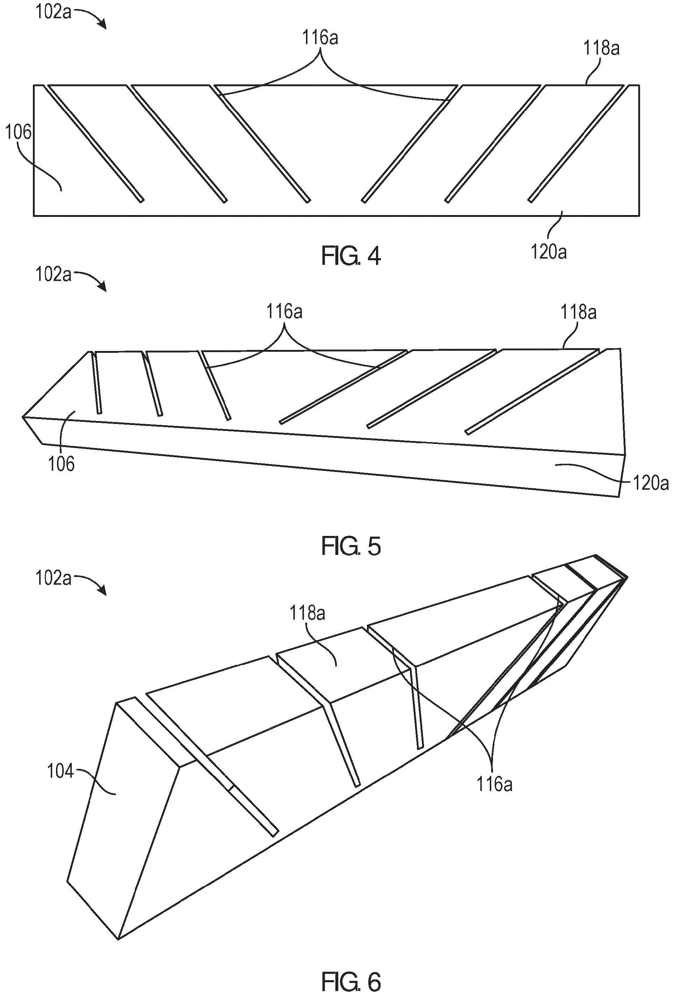

FIGS. 4-6 illustrate another example of a louver 102a. Louver 102a is similar to louver 102 of FIGS. 1 and 3, except that louver 102a includes a plurality of slits 116a extending at least partially through a thickness of louver 102a. Slits 116a are designed to reduce airflow impedance without reducing the noise-dampening qualities of sound absorbing core 104a. Slits 116a may extend entirely through sound reflecting cover 106a and sound absorbing core 104a, or may extend partially or entirely through only sound absorbing core 104a. Slits 116a may extend at a transverse angle relative to a longitudinal axis of louver 102a, and may be mirrored about a central line that bisects louver 102a into two equal halves. Furthermore, slits may extend through one longitudinal end 118a of louver 102a, but not through an opposing longitudinal end 120a. Although six slits 116a are illustrated in FIGS. 4-6, any number of slits may be formed in louver 102a to reduce airflow impedance.

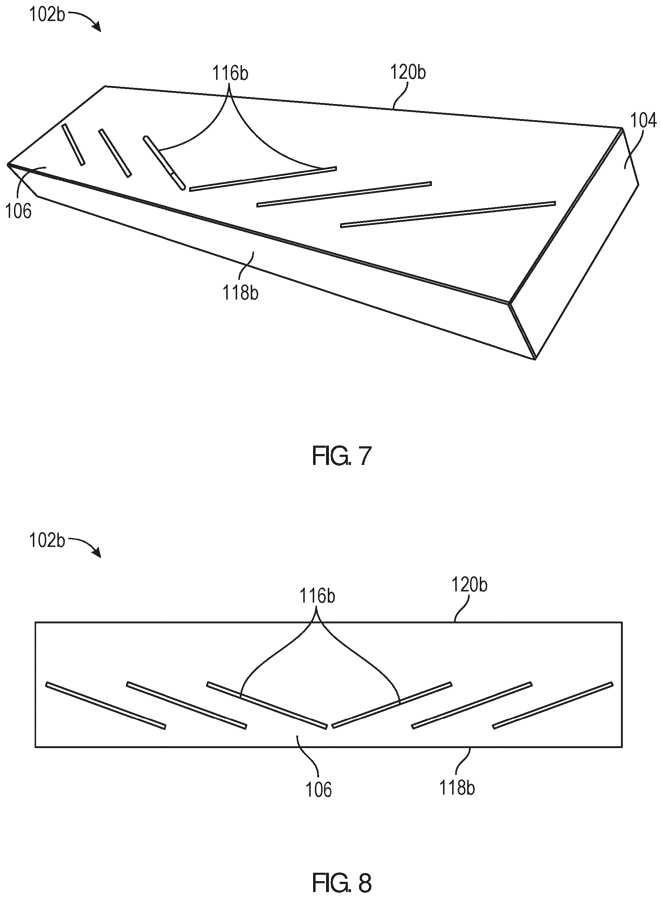

FIGS. 7-8 illustrate another example of a louver 102b. Louver 102b is substantially similar to louver 102a, with some differences noted. For example, slits 116b of louver 102b do not extend through either longitudinal end 118b or longitudinal end 120b. Rather, slits 116b are formed through a central portion of louver 102b without extending through any longitudinal or lateral end portion of louver 102b.

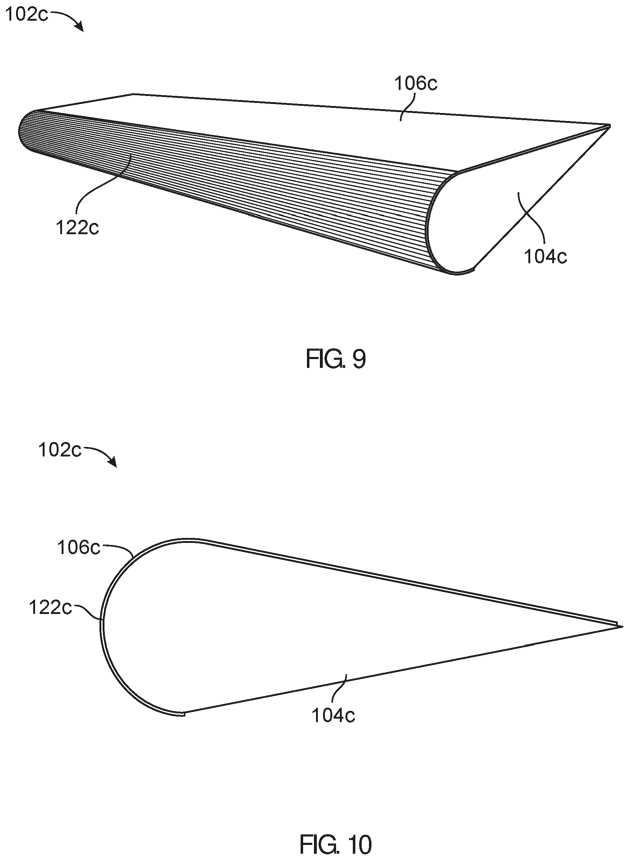

FIGS. 9-10 illustrate another example of a louver 102c. Louver 102c has an airfoil shape rather than a rectangular prismatic shape. As such, louver 102c can act similar to a wing of an airplane and reduce flow impedance as air travels over the curved leading edge 122c. Sound reflective cover 106c extends over the curved leading edge 122c and over a top surface of sound absorbing core 104c, but not over a bottom surface of sound absorbing core 104c such that the sound can be reflected over the top of louver 102c and sound can be absorbed by over the bottom of louver 102 via core 104c. The radius of curvature of leading edge 122c can vary from example to example, to achieve different flow impedances for different implementations.

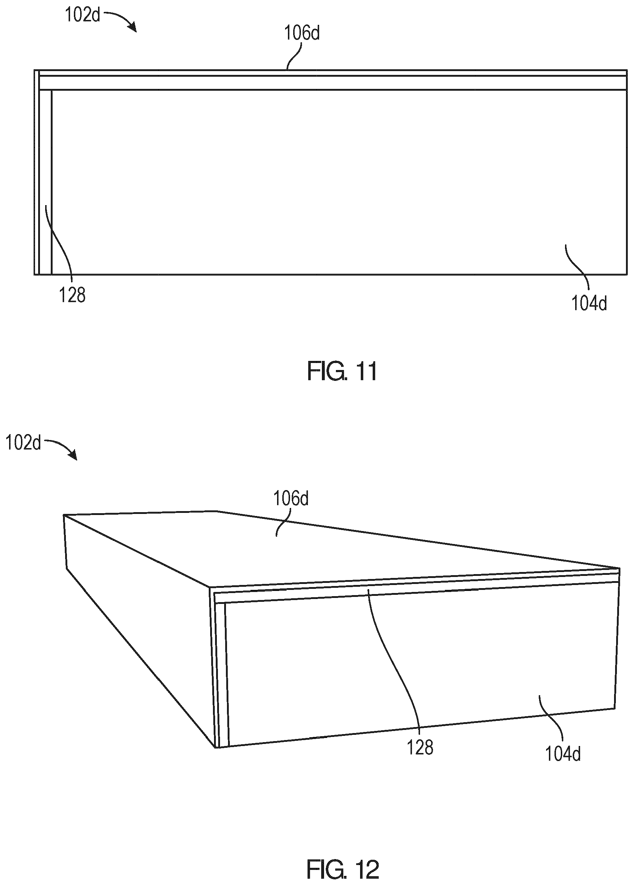

FIGS. 11-12 illustrate another example of a louver 102d. Louver 102d is substantially similar to louvers 102a and 102b, with some differences noted. An electromagnetic interference (EMI) absorbing layer 128 is positioned between sound reflective cover 106d and sound absorbing core 104d. EMI absorbing layer 128 is configured to improve the electromagnetic compatibility (EMC) of the cooling systems, which in turn, reduces electromagnetic emission from the server rack 185. EMI absorbing layer 128 can be a solid material or may be a solid material with a pattern of holes defined therethrough, such as a honeycomb pattern. The EMI absorbing layer 128 can be in different forms and materials, such as solid or porous forms and from foams or ferrites. EMI absorbing layer 128 may be implemented with any of the example louvers disclosed herein and is not specifically limited to louver 102d.

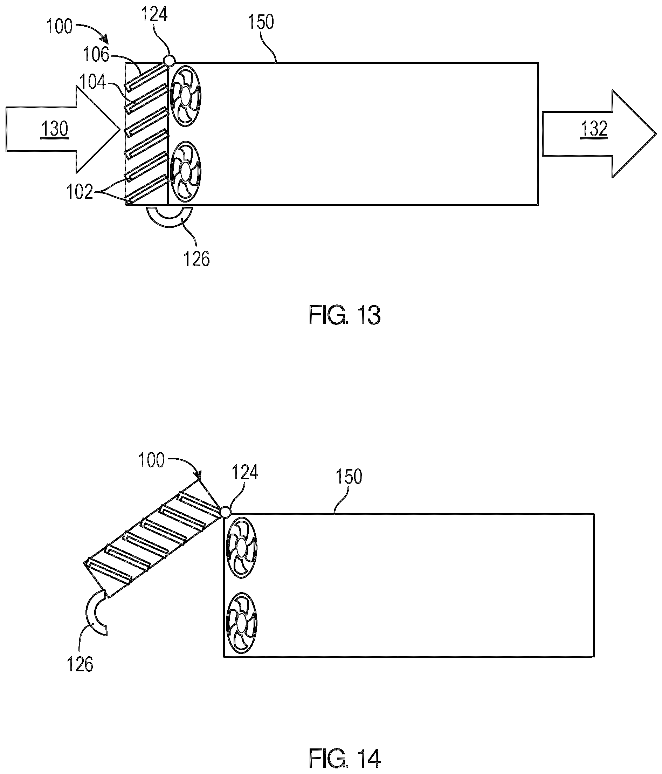

FIGS. 13-14 illustrate an example of louver assembly 100 implemented with a unit of electrical equipment, such as an electrical component 150, e.g., a server. Louver assembly 100 is attached to the electrical component 150 via a hinge 124 extending through an upper portion of louver assembly 100 and electrical component 150. As such, louver assembly 100 is configured to pivot about hinge 124 such that a lower portion of louver assembly 100 pivots away from a lower portion of rack 152 to allow physical access to the front of electrical component 150, as is illustrated in FIG. 13. Hinge 124 may be any hinge known in the art. Alternatively, hinge 124 may be replaced with a sliding mechanism that allows louver assembly 100 to translate relative to electrical component 150, or hinge 124 may be positioned at a bottom portion or side portion of rack 152. A locking mechanism 126 is positioned around a lower end of louver assembly 100 and electrical component 152 to lock the louver assembly 100 in place such that the assembly 100 does not inadvertently pivot away from rack 152 in use. Locking mechanism 126 may be a movable latch or other similar mechanisms known in the art. The locking mechanism 126 along with the louver assembly 100 can provide a tamper protection feature, by hindering, deterring or detecting unauthorized access to the electrical components by locking the locking mechanism 126.

As is illustrated in FIG. 13, in use, louver assembly 100 can be directly adjacent to electrical component 150, such that cooling airflow 130 may pass through individual louvers 102 and into the electrical component 150. After passing through the electrical component 150, warm air 132 is pushed away from the electrical component 150 where the warm air 132 may then be conditioned, expelled to the outside, or recirculated. FIG. 14 illustrates a louver assembly 100 being pivoted away from rack 152 via hinge 124, which may be desirable for serviceability or for access to rack 152. In some examples, louver assembly 100 can be at least partially installed on the rear side of electrical component 152, to reduce noise on the rear side of the component.

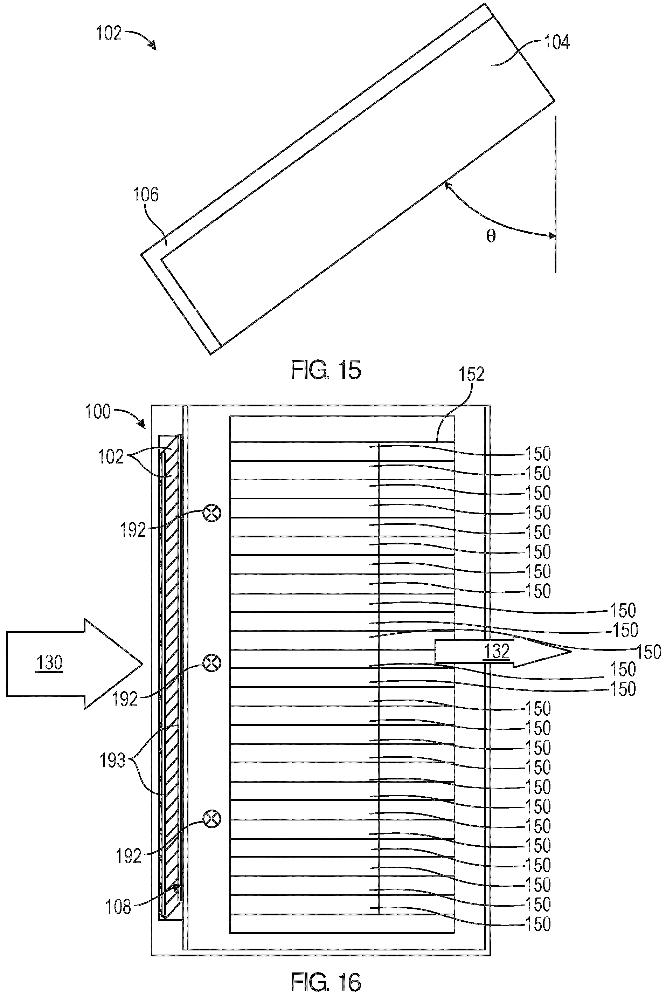

FIGS. 15-16 illustrate other aspects of louver assembly 100 when implemented with a rack 152 of a data center. Louver assembly 100 includes one or more individual louvers 102, each including a sound absorbing core 104 and a sound reflecting cover 106. The louvers 102 are attached to a mechanical linkage system 193 that links individual louvers 102 together to allow changing angle θ. As such, linkage system 193 may be implemented with push/pull rods or other similar mechanical systems. Louver assembly 100 is electrically connected to a louver control system 103 configured to monitor airflow conditions and determine an optimal angle θ.

The louver control system 103 includes at least one microphone sensor 192 positioned within throughout louver assembly 100, throughout door 110, throughout the rack 152, or through spaces between such components. Microphone sensor 192 is configured to detect a noise level adjacent to electrical components 150, and such a noise level may be noise caused by electrical components 150 on rack 152. Based on this noise level, a processor of the control system may determine an optimal angle θ for the various louvers 102. Such a processor may compare measured noise values with values stored in a memory system and may calculate an angle θ based on a difference between the measured parameters and the stored parameters. The control system further comprises a motor, such as a servo, configured to change the attack angle θ of louvers 102.

Several examples of the operation of the control system are disclosed herein. If the control system determines that the noise level of a rack is too high, the angle θ may be lowered such that a larger portion of sound absorbing core 104 faces electrical components 150 and a larger portion of sound reflecting cover 106 reflects inside noise back to the rack. The level of attenuation and airflow impedance caused by louvers 102 are in an inverse relationship. Specifically, the larger the attack angle θ, the higher the noise attenuation level will be while also having a higher pressure drop. Thus, the level of attenuation can be increased by increasing the angle θ based on the desired outcome. The control system can also account for ambient noise levels and take into account the proximity of people within the data center, the time of day, and other external factors that may affect the noise values within the data center.

The control system may also monitor the temperatures of individual pieces of electrical components 150 via temperature sensors. If air temperature at a localized region of the data center such as at a particular rack 152 of electrical components 150, the attack angle θ may be increased such that more cooling airflow 130 may pass through louver assembly 100 and into the rack to improve cooling of servers 150 before the airflow is exhausted as warm air 132.

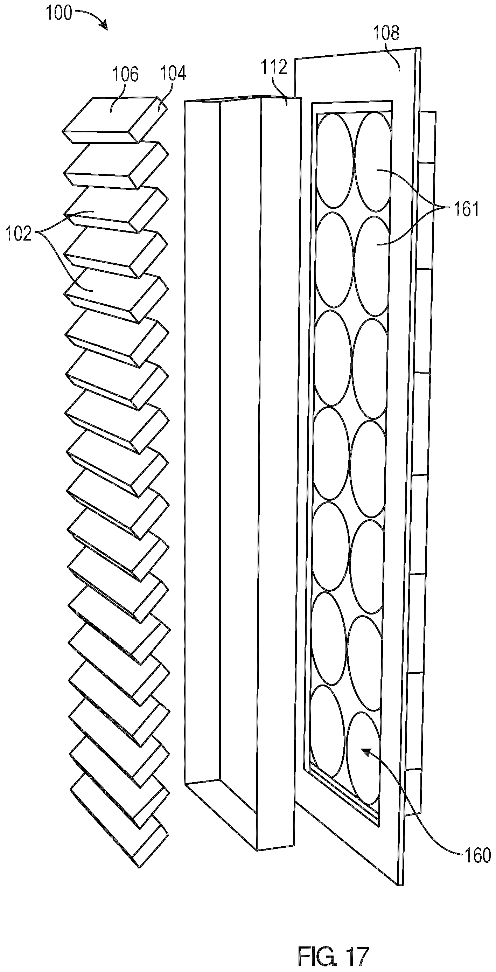

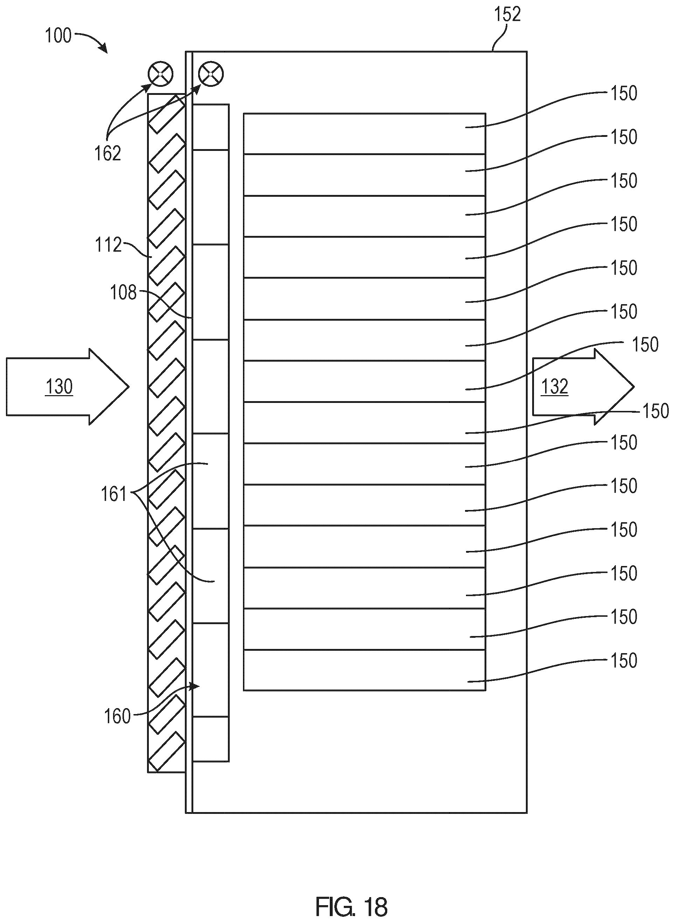

FIGS. 17 and 18 illustrate a louver assembly 100 implemented with a fan assembly 160. As is illustrated in FIG. 15, louvers 102 are assembled into a frame 112, which is then assembled into a door 108. Frame 112 may be rectangular or the frame 112 may be another shape associated with door 108. Fan assembly 160 is mounted on a back side of door 108, for example opposite the side that louvers 102 are mounted. Fan assembly 160 can include one or more of axial fans 161 that are dimensioned to cover a majority of the surface area of door 108. Although fans 161 are illustrated as pairs of fans stacked atop adjacent pairs of fans, in different examples, other fan configurations are possible. Fans 161 of fan assembly 160 are configured to account for flow impedance caused by the louvers 102 and provide additional cooling air to the racks of the data center behind door 108.

FIG. 18 illustrates various pressure sensors 162 that may be positioned on any combination of door 108, frame 112, louver assembly 100, electrical components 150, and any racks 152 of the data centers adjacent door 108. Pressure sensors 162 are configured to communicate with fan assembly 160 to regulate the fan speed to achieve a neutral pressure differential across door 108 when the airflow demand of the rack changes. Fan assembly 160 can be installed on either a front side and/or rear side of a data center rack 152.

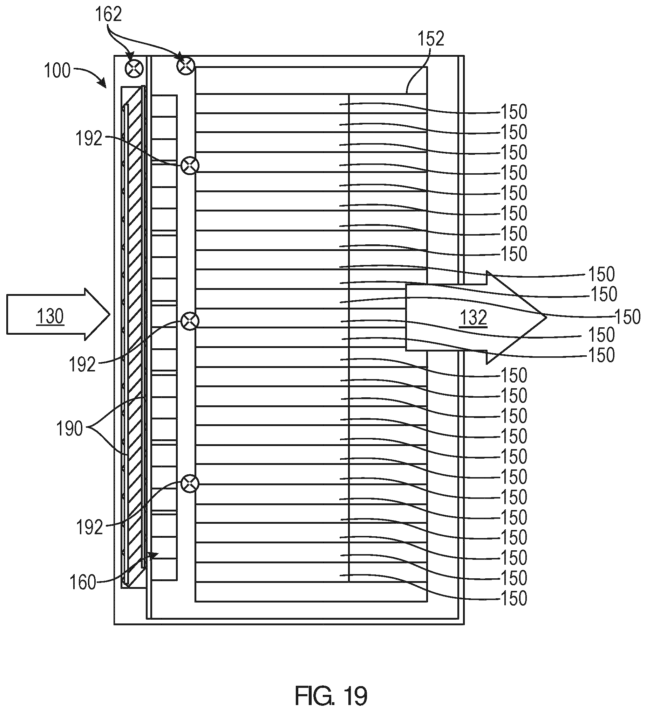

FIG. 19 illustrates other aspects of louver assembly 100 when implemented with a rack 152 of a data center. Louver assembly 100 includes the control system 103 of FIG. 16 and the fan assembly 160 of FIGS. 17-18. As such, the control system is configured to detect parameters from various microphone sensors 192 and from pressure sensors 162. Such parameters can be compared to stored values by a processor of the control system, and various measures may be taken if the measured values meet or exceed predetermined threshold values. These measures include correcting the angle θ of louvers 102 and changing the fan 161 speed. The control system 103 is also electrically connected to fan assembly 160 and is configured to control the fan speed based on a sensed temperature value and sensed noise value. The speed of the fans can also be controlled in proportion to the angle θ of louvers 102 to control the temperature and noise values within the rack and to account for the pressure drop caused by louvers 102. The control system may be powered by a battery mounted within louver assembly 100 or within rack 152, or the control system may be powered by a standard electrical outlet or other source of power. The control system may also be connected to a display unit mounted to rack 152. Such a display unit is configured to show various temperature and atmospheric conditions within the data center. Additionally, the display unit may show remaining battery life of louver assembly 100 and the associated control system, and information about the associated rack 152. The display unit allows an operator to select various parameters of louver assembly 100 manually, such as angle θ, to direct airflow toward rack 152.

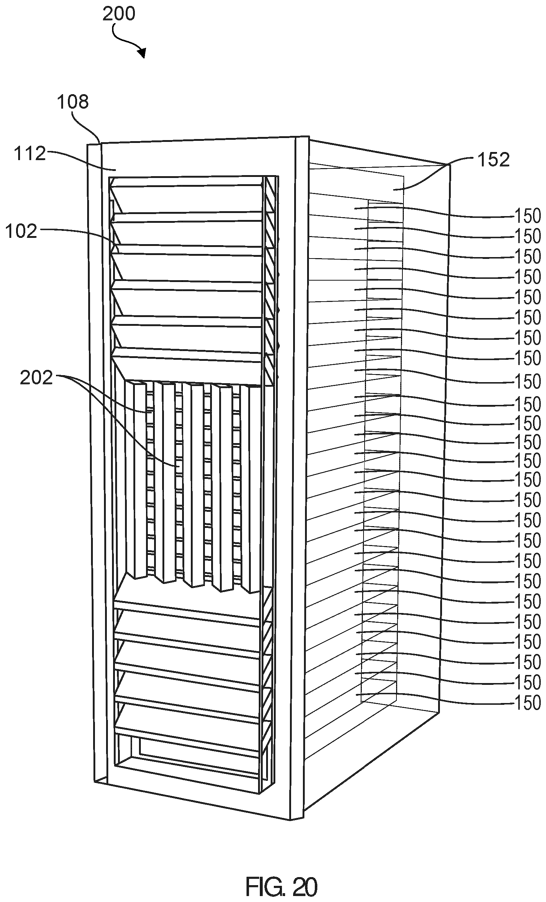

FIG. 20 illustrates another example of a louver assembly 200. Louver assembly 200 is substantially similar to louver assembly 100, and thus the similarities will not be described for sake of brevity. Louver assembly 200 includes one or more horizontally arranged louvers 102 and one or more of vertically arranged louvers 202. Vertical louvers 202 may be advantageous for certain door shapes and particularly for narrow doors. Any number of vertical louvers 202 may be implemented with or without any number of horizontal louvers 102. The louvers extending at transverse angles relative to door 108 may also be implemented alone or in combination with louvers 102 and/or louvers 202.

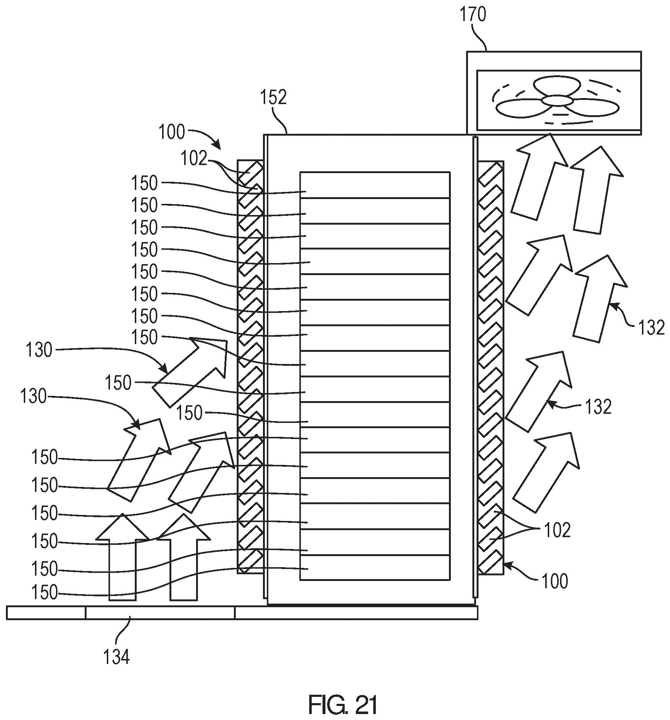

FIG. 21 illustrates a louver assembly implemented in a broader context of a data center. Cooling airflow 130 may be drawn from a cool airflow supply source 134, such as a perforated floor tile, HVAC system, and the like. Cooling airflow 130 may pass through a first louver assembly 100a before being distributed to electrical components 150 within a rack of the data center. As the air passes over the warm electrical components 150, As described herein, louvers of the louver assembly 100a can be modulated in angle to redirect airflow from source 134 to the electrical components 150. The air absorbs heat and then passes through a second louver assembly 100b as warm air 132. Second louver assembly 100b is positioned such that second louver assembly 100b, for example through corresponding louvers modulated as described herein, redirects warm air 132 to an exhaust system 170. Exhaust system 170 may have any type of exhaust fan system known in the art that is configured to expel warm air 132 away from electrical components 150. Exhaust system 170 may also be configured to recirculate and/or condition air such that the air can be resupplied to the electrical components 150.

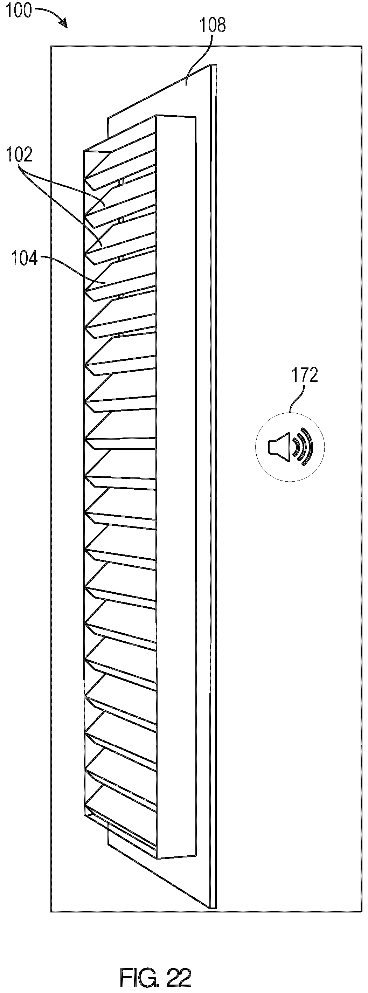

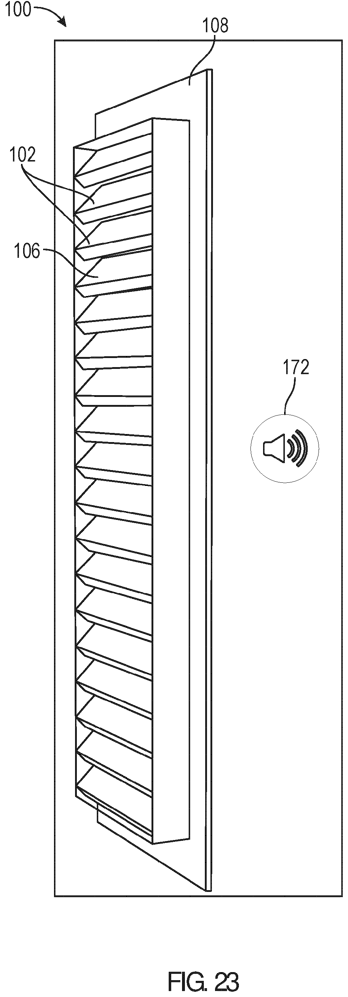

FIGS. 22-23 illustrate the adaptability of louver assembly 100 for different implementations. Specifically, FIG. 22 illustrates a louver assembly 100 including one or more louvers 102 with a sound absorbing core 104 facing inwards facing the noise source 172. Noise source 172 can be an IT equipment such as server 150. Alternatively, FIG. 23 illustrates a louver assembly 100 including one or more louvers 102 with a sound reflecting cover 106 facing the noise source 172.

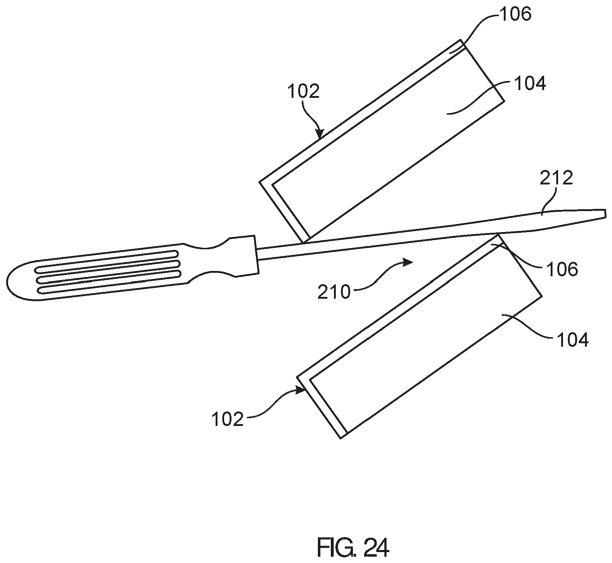

FIG. 24 illustrates a tamper detection mechanism 210 according to one example. The purpose of a tamper detection mechanism is to hinder, deter or detect unauthorized access to a device housed in a server rack. Tamper detection mechanism 210 operates by supplying an electrical current (not shown) to adjacent louvers and monitoring that current over a period of time to ensure the electrical current stays consistent between adjacent louvers 102. If a conductive object 212, such as a screwdriver, is placed between louvers 102 such that the conductive object 212 touches the conductive sound reflecting covers 106 of adjacent louvers 102, a short circuit forms between the adjacent louvers 102, and an alert can be created to signal that tampering is occurring.

The louver control system 103 may be implemented to measure the difference in electrical potential over a period of time. Such a control system may also be electrically connected to various displays, alarms, and/or other alert systems that are triggered if tampering of louver assembly 100 is detected. The control system may be powered by a power supply that is also used to power the various sensor systems, fan systems, and other electrical systems disclosed herein.

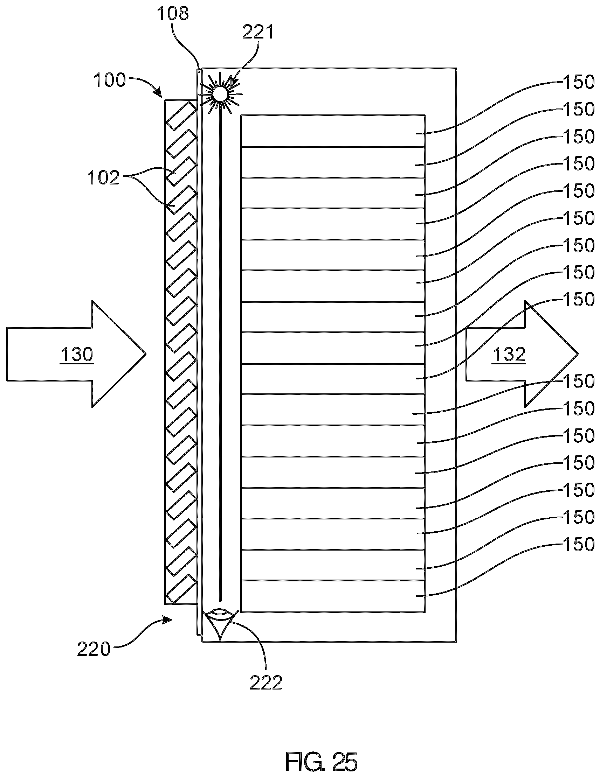

FIG. 25 illustrates another implementation of a tamper detection mechanism 220. Tamper detection mechanism 220 operates similarly to tamper detection mechanism 210, albeit tamper detection mechanism 220 monitors optics rather than electrical potential. An optical source 221 is positioned between frame 108 and electrical components 150. Optical source 221 may be a light emitting diode (LED), laser, or another optical source configured to create a thin sheet of light between louver assembly 100 and electrical components 150. At least one optical detector 222 is positioned across from optical source 221 and is configured to receive light and communicate with a control system if a change in the monitored optics is detected, such as blocked light or a displacement of the sheet of light, is detected over a period of time. Such tampering may occur from extending tools between louver assembly 100 and electrical components 150, or otherwise entering the space between louver assembly 100 and electrical components 150. Similar to the control system of tamper detection mechanism 210, the control system of tamper detection mechanism 220 may be connected to various displays, alarms, and/or other alert systems to alert a user if tampering is detected.

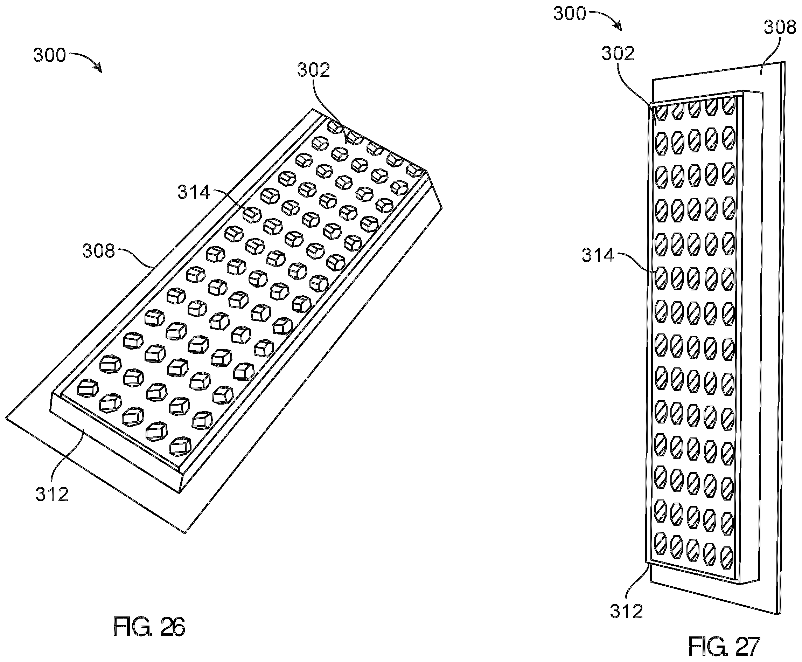

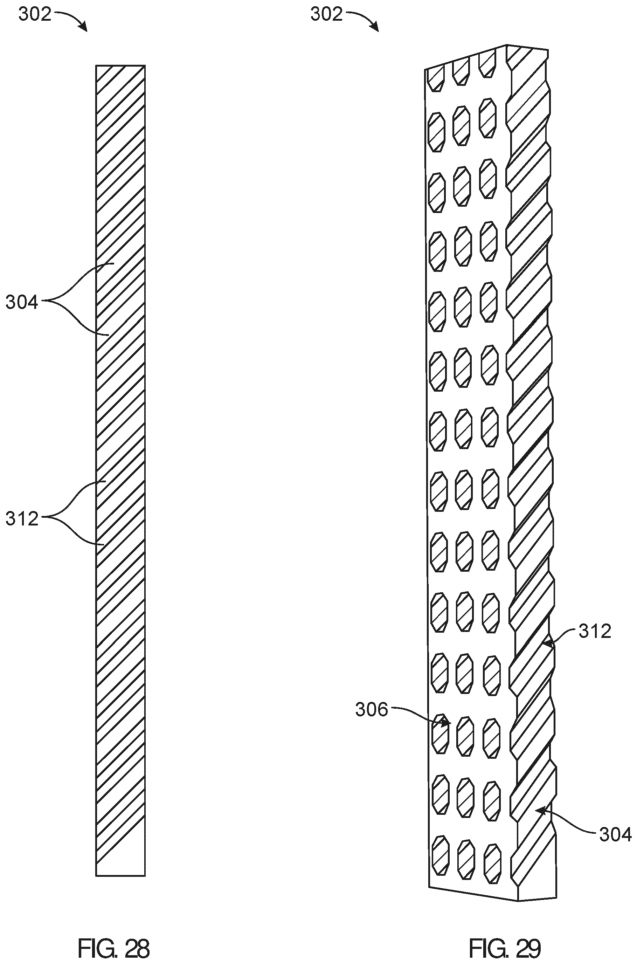

FIGS. 26-29 illustrate an implementation of an acoustic door system for dampening noise. Acoustic door 300 does not necessarily implement louvers, and rather relies on a perforated plate attached to a door that allows air to pass therethrough. As illustrated in FIG. 26-27, acoustic door 300 includes a perforated plate 302 including one or more openings 314 configured to allow air to pass therethrough. Perforated plate 302 is attached to a frame 312 that makes up a door 308. Frame 312 may be rectangular as shown or another shape depending on the implementation. Plate 302 includes a noise reflecting cover 306 placed over a noise absorbing core 304 such that the plate is optimally configured to control sound properties within a data center. Noise reflecting cover 306 extends over at least one surface of plate 302 but may extend over multiple surfaces if additional sound reflecting properties are desired. An EMI absorbing layer (not shown) can be positioned between noise reflecting cover 306 and noise absorbing core 304.

Plate 302 includes seventy openings 314, each opening spaced apart from adjacent openings and positioned in rows of five. The number of openings 302 within a row and the number of rows may be modified for various implementations. For example, for implementations requiring greater sound dampening, a plate 302 with fewer than 70 openings may be implemented. Likewise, the size of openings 314 may vary depending on the particular implementation. Openings 314 may be cylindrical as illustrated or may be another rectangular or another shape that aids in manufacturing capabilities. Openings 314 are preferably angled relative to a longitudinal axis of frame 312, as illustrated in FIG. 24. Specifically, each opening 302 in a row of openings may be oriented at the same angle as the adjacent opening to provide for uniform airflow through a row of openings. Each row may also be angled at the same orientation relative to the adjacent rows, or each row may be angled differently to provide different airflow patterns.

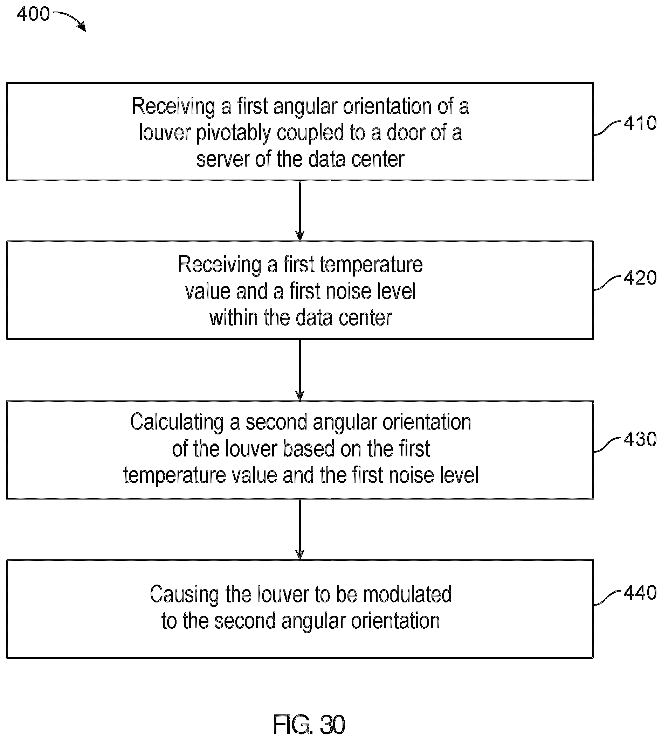

FIG. 30 is a flow diagram of an example process 400 for modulating a louver assembly, according to aspects of the disclosure. For example, a control system and a louver assembly, such as the louver control system 103 and the louver assembly 100 of FIGs. 1-2, can perform the process 400. The operations of example processes described herein do not have to be performed in the precise order described below. Rather, various operations can be handled in a different order or simultaneously, and operations may be added or omitted. In some examples, multiple processes are performed together.

The control system receives an initial louver position for each individual louver of the louver assembly, according to block 410. This louver position may refer to the angular orientation of the louver relative to the door frame of the server door. The control system may also receive a first angular orientation of a second louver pivotably coupled to the server door.

The control system also receives a first temperature value and a first noise level within the data center, according to block 420. Such detection can occur using sensing system 189, which may include the various sensors disclosed herein, such as a temperature sensor and/or pressure sensor positioned on a rack of the data center and a microphone sensor positioned on a door of the rack. The control system also calculates a second angular orientation of the louver based on the first temperature value and the first noise level, according to block 430. Such a calculation may be accomplished by the various processors disclosed herein. The control system may also receive and calculate an angular orientation of a second louver pivotably coupled to the server door based on the sensed temperature values and noise levels. Such a calculation can be accomplished by comparing the first sensor value and the first noise level to a stored temperature value and a stored noise level.

The control system also modulates the louver to the second angular orientation according to block 440. The control system may additionally modulate the second louver to a second angular orientation different from the first angular orientation of the second louver. Various subsequent steps may include continued monitoring of temperature and noise within the rack after modulation of the louver. Additionally, the control system may modulate multiple louvers to different angular orientations to adjust the temperature and noise within the rack. The control system is configured to display the first and second angular orientations of the louver on a display. Additionally, the control system is configured to send an alert in response to a determination that at least one of the first temperature or pressure value and a first noise level within the data center exceed at least one of a threshold temperature value and a threshold noise level.

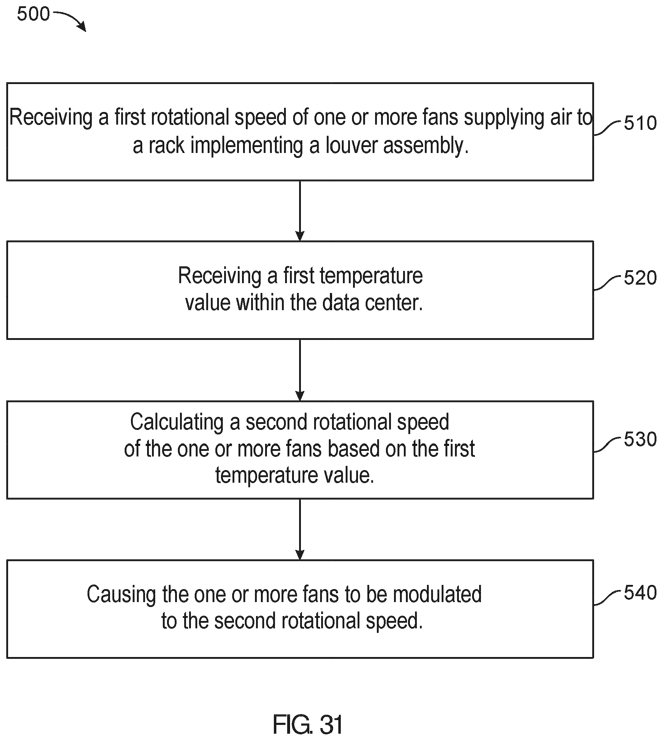

FIG. 31 is a flowchart of an example process 500 for implementing a louver assembly according to aspects of the disclosure. The louver assembly may be an assembly with fixed louvers, meaning that the angle of the louvers cannot be modulated. In examples in which the louver assembly includes fixed louvers, a control system can modulate the speed of fans supplying air,

A control system receives a first rotational speed of one or more fans supplying air to a rack implementing a louver assembly, according to block 510. For example, the fans may be part of a fan assembly 160, as described herein with reference to FIGS. 17-18

The control system receives a first temperature value within the data center, according to block 520. Sensing system 189 can be used to measure and provide the first temperature value, using, for example, a temperature sensor on or within a rack implementing the louver assembly.

The control system calculates a second rotational speed of the one or more fans, based on the first temperature value, according to block 530. As described herein with reference to FIG. 30, the control system can calculate a second rotational speed based on stored temperature values, which may correspond to different speeds. The control system can compare the first temperature value with stored values for determining the second rotational speed. In some examples, the control system can receive additional signals from other sensors, e.g., noise levels based on pressure values, which can be further used to calculate the second rotational speed.

The control system causes the one or more fans to be modulated to the second rotational speed, according to block 540. For example, the control system can be configured to send a signal to a fan assembly including the one or more fans, which may further include a microprocessor or some control unit for receiving signals and modulating the speed of the fans based on the signal. To that end, the control system can facilitate the modulation of fan speed for controlling the supply of air, which in turn impacts the noise level and temperature of racks and electrical components within a data center.

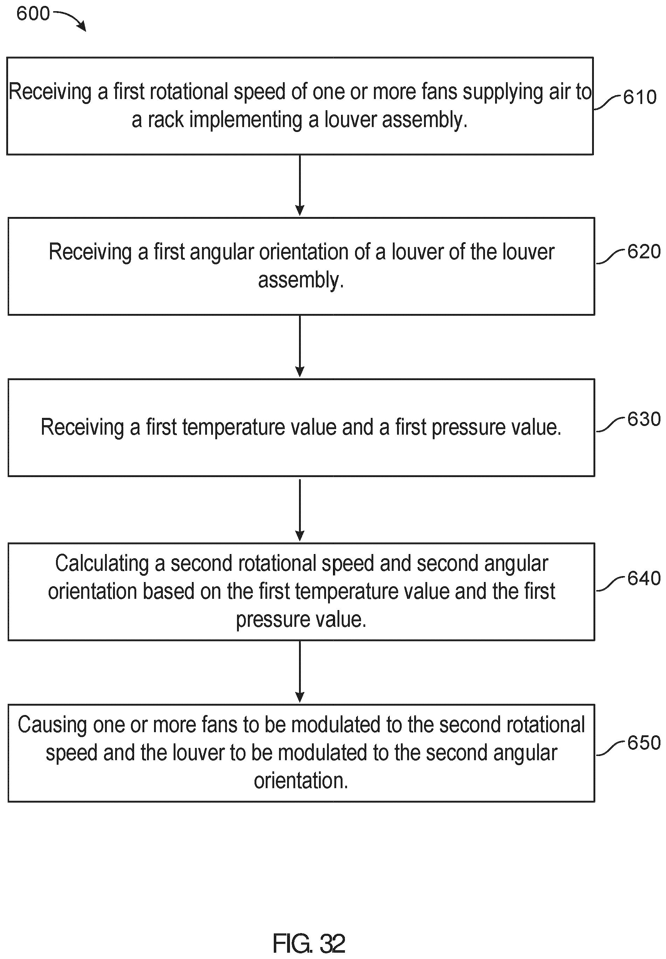

FIG. 32 is a flowchart of an example process 600 for implementing a louver assembly according to aspects of the disclosure. In the example process 600, both the rotational speed of the fans supplying air to a rack implementing the louver assembly, as well as angular orientation of louvers in the assembly are modulated based on different sensed signals.

A control system receives a first rotational speed of one or more fans supplying air to a rack implementing the louver assembly, according to block 610.

The control system receives a first angular orientation of a louver of the louver assembly, according to block 620. The process 600 according to blocks 610 and 620 may be compared with blocks 510 and 410 of FIGs. 31 and 30, respectively.

The control system receives a first temperature value and a first pressure value, according to block 630. The temperature value and pressure values can be measured using sensors on or within the rack implementing the louver assembly, for example using temperature and pressure sensors described herein.

The control system calculates a second rotational speed and a second angular orientation based on the first temperature value and the first pressure value, according to block 640. As described herein, for example with reference to FIGs. 30 and 31, the control system can calculate rotational speeds and angular orientations based on stored values of temperature and pressure corresponding to different rotational speeds and angular orientations. In some examples, the control system can implement a function or set of executed instructions for calculating the rotational speed and/or angular orientation as a function of temperature, pressure, and/or other measurements taken by sensors on or within the rack.

The control system causes one or more fans to be modulated to the second rotational speed and the louver to be modulated to the second angular orientation, according to block 650. As described herein, for example with reference to FIGs. 30 and 31, the control system can generate and transmit signals for causing either a fan assembly or the louver assembly to change the rotational speed or the one or more fans or the angular orientation of the louver, respectively. In some examples, the control system may cause only one of the fans or the louver to modulate. In some examples, the control system causes multiple louvers of the louver assembly to be modulated.

The louver assemblies allow for both increased airflow into the data centers and for a decrease in overall noise pollution. The louver assemblies can also communicate with a control system that automates cooling cycles to account for external factors such as the time of day, ambient noise volume, number of workers within the data center, etc. The control system can modulate the angle of attack for the individual louvers to balance improving air flow to the servers, with adjusting in response to different levels of tolerated noise volume. The louver assemblies can also implement layers of electromagnetic shielding material that limit the overall electromagnetic interference levels within the data center. In some examples, when a rack is serviced, louvers of adjacent racks can be adjusted to reduce noise exposure on the operator from the adjacent racks.

Implementations of the present technology can each include, but are not limited to, the following. The features may be alone or in combination with one or more other features described herein. In some examples, the following features are included in combination:
(1) A door system for supplying air to a data center including: a door; a frame mounted to the door; and a plurality of louvers positioned in the frame such that the plurality of louvers extends at least partially across an opening defined through the door, wherein each louver of the plurality of louvers includes a respective sound absorbing core at least partially surrounded by a sound reflecting cover.
(2) The door system of (1), further including a control system configured to modulate at least one louver to change an angular orientation of the at least one louver relative to the door.
(3) The door system of (2), wherein the control system further includes one or more processors and one or more sensors, the one or more processors configured to: receive sensor data including measurements from the one or more sensors; and determine that the measurements meet or exceed respective threshold measurement values; and in response to determining that the measurements are different from the respective threshold measurement values, change the angular orientation of at least one louver relative to the door.
(4) The door system of (3), wherein: the one or more sensors include at least one of a temperature sensor configured to measure temperature within the data center, a pressure sensor configured to measure air pressure within the data center, and a microphone configured to measure sound levels in the data center; and the respective threshold measurement values include at least one of a temperature measurement threshold, an air pressure measurement threshold, or a sound level measurement threshold.
(5) The door system of either (3) or (4), wherein the control system further includes a display mounted to a rack of the data center, the display configured to show a difference between the measurements of the sensor data and the respective threshold measurement values for the sensor data.
(6) The door system of any one of (3) through (5), wherein the one or more sensors are positioned on a rack adjacent to the door.
(7) The door system of any one of (2) through (6), wherein the control system further includes a motor mechanically linked to the plurality of louvers, the motor configured to modulate each louver of the plurality of louvers individually and together.
(8) A door system for supplying air to a data center including: a plate including an inner sound absorbing core at least partially surrounded by an outer sound reflecting cover and a plurality of openings defined entirely through a thickness of the plate, each opening of the plurality of openings defining a central axis transverse to a plane defined between the plate and the door; and a frame mounted to the door and configured to receive the plate.
(9) The door system of (8), further including an electromagnetic interference shielding layer positioned between the sound absorbing core and the sound reflecting cover.
(10) The door system of (8) or (9), wherein a central axis of a first opening of the plurality of openings extends at a first transverse angle and a second central axis defined by a second opening of the plurality of openings extends at a second transverse angle different from the first transverse angle.
(11) The door system of any one of (8) through (10), wherein an opening of the plurality of openings is cylindrical.
(12) The door system of any one of (8) through (11), wherein the plate further includes an electromagnetic interference (EMI) absorbing layer between the inner sound absorbing core and the outer sound reflecting cover.
(13) The door system of any one of (8) through (12), wherein the control system further includes an optical source positioned between the door and a rack of the data center and configured to create a sheet of light detectable by an optic sensor; and is further configured to monitor a change in light intensity caused by displacement of the sheet of light.
(14) The door system of (13), wherein the sound reflecting cover extends around the curved leading edge.
(15) The door system of any one of (1) through (13), wherein at least one louver of the plurality of louvers is horizontally arranged over the opening.
(16) The door system of any one of (1) through (15), wherein at least one louver of the plurality of louvers is vertically positioned over the opening.
(17) The door system of (16), wherein the control system is configured to send an alert to a user when the difference in electrical potential is detected.
(18) The door system of (8), further including any one of (1) through (7) and/or (10) through (17).
(19) A door system for supplying air to a data center including:
   a plurality of louvers pivotably mounted in a frame of the door such that the plurality of louvers extends at least partially across an opening defined through the door, wherein each louver of the plurality of louvers includes a respective sound absorbing core at least partially surrounded by a sound reflecting cover;
   a fan assembly mounted to the door and configured to supply air toward a rack of the data center; and
   a control system configured to modulate at least one louver of the plurality of louvers and at least one fan of the fan assembly to regulate a temperature and noise level of the data center.
(20) The door system of (19), wherein the fan assembly includes a plurality of axial fans.
(21) The door system of (20), wherein the control system is configured to modulate speed of individual fans of the plurality of axial fans to direct air toward the rack.
(22) The door system of (20) or (21), wherein the control system is configured to modulate speed of individual fans based on a signal received from a pressure sensor mounted on the rack.
(23) The door system of (19), further including any one of (1) through (18) and/or (19) through (22).
(24) A door system for supplying air to a data center including: a plurality of louvers pivotably mounted in a frame of the door such that the plurality of louvers extends at least partially across an opening defined through the door, wherein each louver of the plurality of louvers includes a respective sound absorbing core at least partially surrounded by a sound reflecting cover; and a control system configured to modulate at least one louver of the plurality of louvers when at least one of a sensed temperature, pressure, or sound value exceeds a respective threshold temperature, pressure, or sound value.
(25) The door system of (24), wherein at least one louver is a rectangular prism such that the sound reflecting cover extends over two adjacent surfaces of the sound absorbing core.
(26) The door system of (24) or (25), wherein at least one louver is foil shaped to define a curved leading edge and a trailing pointed edge.
(27) The door system of any one of (24) through (26), wherein at least one louver of the plurality of louvers includes an electromagnetic interference layer positioned between the sound absorbing core and the sound reflective cover.
(28) The door system of any one of (24) through (28), wherein the control system is configured to supply an electrical current to sound reflective covers of the plurality of louvers and monitor the electrical current to detect a difference in electrical potential caused by a short circuit formed between adjacent louvers.
(29) The door system of (24), further including any one of (1) through (23) and/or (25) through (28).
(30) A method for supplying air to a data center including: receiving, by one or more processors, a first angular orientation of a louver pivotably coupled to a door of a server of the data center; receiving, by the one or more processors, a first temperature value and a first noise level within the data center; calculating, by the one or more processors, a second angular orientation of the louver based on the first temperature value and the first noise level; and causing, by the one or more processors, the louver to be modulated to the second angular orientation.
(31) The method of (30), wherein receiving the first temperature value includes receiving the first temperature value from a temperature sensor positioned on a rack of the data center and receiving the first noise level from a microphone sensor positioned on the door of the data center.
(32) The method of (30) or (31), further including receiving, by the one or more processors, a first angular orientation of a second louver pivotably coupled to the door of the server.
(33) The method of (32), further including calculating, by the one or more processors, a second angular orientation of the second louver based on the first temperature value and the first noise level.
(34) The method of (33), further including causing, by the one or more processors, the second louver to be modulated to a second angular orientation different from the first angular orientation of the second louver.
(35) The method of any one of (30) through (34), wherein calculating the second angular orientation of the louver includes comparing the first temperature value and the first noise level to a stored temperature value and a stored noise level.
(36) The method of any one of (30) through (35), further including sending, by the one or more processors, an alert in response to a determination that at least one of the first temperature value and a first noise level within the data center exceed at least one of a threshold temperature value and a threshold noise level.
(37) A system including one or more processors configured to perform operations as in the method of any one of (30) through (36).
(38) One or more non-transitory computer-readable storage media storing instructions that are operable, when executed by one or more processors, to cause the one or more processors to perform operations as in any one of (30) - (36).

Although the implementations disclosed herein have been described with reference to particular features, it is to be understood that these features are merely illustrative of the principles and applications of the present implementations. It is therefore to be understood that modifications, including changes in the sizes of the various features described herein, may be made to the illustrative implementations and that other arrangements may be devised without departing from the scope of the present implementations. In this regard, the present implementations encompass numerous additional features in addition to those specific features set forth in the paragraphs above.

Aspects of this disclosure can be implemented in digital electronic circuitry, in tangibly-embodied computer software or firmware, and/or in computer hardware, such as the structure disclosed herein, their structural equivalents, or combinations thereof. Aspects of this disclosure can further be implemented as one or more computer programs, such as one or more modules of computer program instructions encoded on a tangible non-transitory computer storage medium for execution by, or to control the operation of, one or more data processing apparatus. The computer storage medium can be a machine-readable storage device, a machine-readable storage substrate, a random or serial access memory device, or combinations thereof. The computer program instructions can be encoded on an artificially generated propagated signal, such as a machine-generated electrical, optical, or electromagnetic signal, that is generated to encode information for transmission to suitable receiver apparatus for execution by a data processing apparatus.

The term "configured" is used herein in connection with systems and computer program components. For a system of one or more computers to be configured to perform particular operations or actions means that the system has installed on it software, firmware, hardware, or a combination thereof that cause the system to perform the operations or actions. For one or more computer programs to be configured to perform particular operations or actions means that the one or more programs include instructions that, when executed by one or more data processing apparatus, cause the apparatus to perform the operations or actions.

The term "data processing apparatus" refers to data processing hardware and encompasses various apparatus, devices, and machines for processing data, including programmable processors, a computer, or combinations thereof. The data processing apparatus can include special purpose logic circuitry, such as a field programmable gate array (FPGA) or an application specific integrated circuit (ASIC). The data processing apparatus can include code that creates an execution environment for computer programs, such as code that constitutes processor firmware, a protocol stack, a database management system, an operating system, or combinations thereof.

The data processing apparatus can include special-purpose hardware accelerator units for implementing machine learning models to process common and compute-intensive parts of machine learning training or production, such as inference or workloads. Machine learning models can be implemented and deployed using one or more machine learning frameworks, such as static or dynamic computational graph frameworks.

The term "computer program" refers to a program, software, a software application, an app, a module, a software module, a script, or code. The computer program can be written in any form of programming language, including compiled, interpreted, declarative, or procedural languages, or combinations thereof. The computer program can be deployed in any form, including as a standalone program or as a module, component, subroutine, or other unit suitable for use in a computing environment. The computer program can correspond to a file in a file system and can be stored in a portion of a file that holds other programs or data, such as one or more scripts stored in a markup language document, in a single file dedicated to the program in question, or in multiple coordinated files, such as files that store one or more modules, sub programs, or portions of code. The computer program can be executed on one computer or on multiple computers that are located at one site or distributed across multiple sites and interconnected by a data communication network.

The term "engine" refers to a software-based system, subsystem, or process that is programmed to perform one or more specific functions. The engine can be implemented as one or more software modules or components or can be installed on one or more computers in one or more locations. A particular engine can have one or more computers dedicated thereto, or multiple engines can be installed and running on the same computer or computers.

The processes and logic flows described herein can be performed by one or more computers executing one or more computer programs to perform functions by operating on input data and generating output data. The processes and logic flows can also be performed by special purpose logic circuitry, or by a combination of special purpose logic circuitry and one or more computers.

A computer or special purpose logic circuitry executing the one or more computer programs can include a central processing unit, including general or special purpose microprocessors, for performing or executing instructions and one or more memory devices for storing the instructions and data. The central processing unit can receive instructions and data from the one or more memory devices, such as read only memory, random access memory, or combinations thereof, and can perform or execute the instructions. The computer or special purpose logic circuitry can also include, or be operatively coupled to, one or more storage devices for storing data, such as magnetic, magneto optical disks, or optical disks, for receiving data from or transferring data to. The computer or special purpose logic circuitry can be embedded in another device, such as a mobile phone, a personal digital assistant (PDA), a mobile audio or video player, a game console, a Global Positioning System (GPS), or a portable storage device, e.g., a universal serial bus (USB) flash drive, as examples. Computer readable media suitable for storing the one or more computer programs can include any form of volatile or non-volatile memory, media, or memory devices. Examples include semiconductor memory devices, e.g., EPROM, EEPROM, or flash memory devices, magnetic disks, e.g., internal hard disks or removable disks, magneto optical disks, CD-ROM disks, DVD-ROM disks, or combinations thereof.

Aspects of the disclosure can be implemented in a computing system that includes a back-end component, e.g., as a data server, a middleware component, e.g., an application server, or a front-end component, e.g., a client computer having a graphical user interface, a web browser, or an app, or any combination thereof. The components of the system can be interconnected by any form or medium of digital data communication, such as a communication network. Examples of communication networks include a local area network (LAN) and a wide area network (WAN), e.g., the Internet.

The computing system can include clients and servers. A client and server can be remote from each other and interact through a communication network. The relationship of client and server arises by virtue of the computer programs running on the respective computers and having a client-server relationship to each other. For example, a server can transmit data, e.g., an HTML page, to a client device, e.g., for purposes of displaying data to and receiving user input from a user interacting with the client device. Data generated at the client device, e.g., a result of the user interaction, can be received at the server from the client device.

It should be noted that the drawings are in simplified form and are not drawn to precise scale. Although at least two variations are described herein, other variations may include aspects described herein combined in any suitable manner having combinations of all or some of the aspects described.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description of the examples should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many examples. Further, the same reference numbers in different drawings can identify the same or similar elements.

## Claims

1. A door system for supplying air to a data center comprising:
a door;
a frame mounted to the door; and
a plurality of louvers positioned in the frame such that the plurality of louvers extends at least partially across an opening defined through the door, wherein each louver of the plurality of louvers includes a respective sound absorbing core at least partially surrounded by a sound reflecting cover.

2. The door system of claim 1, further comprising a control system configured to modulate at least one louver to change an angular orientation of the at least one louver relative to the door.

3. The door system of claim 2, wherein the control system further comprises one or more processors and one or more sensors, the one or more processors configured to:
receive sensor data comprising measurements from the one or more sensors; and
determine that the measurements meet or exceed respective threshold measurement values; and
in response to determining that the measurements are different from the respective threshold measurement values, change the angular orientation of at least one louver relative to the door.

4. The door system of claim 3, wherein:
the one or more sensors comprise at least one of a temperature sensor configured to measure temperature within the data center, a pressure sensor configured to measure air pressure within the data center, and a microphone configured to measure sound levels in the data center; and
the respective threshold measurement values comprise at least one of a temperature measurement threshold, an air pressure measurement threshold, or a sound level measurement threshold.

5. The door system of claim 3 or claim 4, wherein the control system further comprises a display mounted to a rack of the data center, the display configured to show a difference between the measurements of the sensor data and the respective threshold measurement values for the sensor data; and/or
wherein the one or more sensors are positioned on a rack adjacent to the door.

6. The door system of any one of claims 2 to 5, wherein the control system further comprises a motor mechanically linked to the plurality of louvers, the motor configured to modulate each louver of the plurality of louvers individually and together.

7. A door system for supplying air to a data center comprising:
a door;
a plate including an inner sound absorbing core at least partially surrounded by an outer sound reflecting cover and a plurality of openings defined entirely through a thickness of the plate, each opening of the plurality of openings defining a central axis transverse to a plane defined between the plate and the door; and
a frame mounted to the door and configured to receive the plate.

8. The door system of claim 7, further comprising an electromagnetic interference shielding layer positioned between the sound absorbing core and the sound reflecting cover.

9. The door system of claim 7 or claim 8, wherein a central axis of a first opening of the plurality of openings extends at a first transverse angle and a second central axis defined by a second opening of the plurality of openings extends at a second transverse angle different from the first transverse angle.

10. The door system of any one of claims 7 to 9, wherein an opening of the plurality of openings is cylindrical; and/or
wherein the plate further comprises an electromagnetic interference (EMI) absorbing layer between the inner sound absorbing core and the outer sound reflecting cover.

11. The door system of any one of claims 7 to 10, wherein the control system
further comprises an optical source positioned between the door and a rack of the data center and configured to create a sheet of light detectable by an optic sensor; and
is further configured to monitor a change in light intensity caused by displacement of the sheet of light.

12. A method for supplying air to a data center comprising:
receiving, by one or more processors, a first angular orientation of a louver pivotably coupled to a door of a server of the data center;
receiving, by the one or more processors, a first temperature value and a first noise level within the data center;
calculating, by the one or more processors, a second angular orientation of the louver based on the first temperature value and the first noise level; and
causing, by the one or more processors, the louver to be modulated to the second angular orientation.

13. The method of claim 12, wherein receiving the first temperature value comprises receiving the first temperature value from a temperature sensor positioned on a rack of the data center and receiving the first noise level from a microphone sensor positioned on the door of the data center.

14. The method of claim 12 or claim 13, further comprising receiving, by the one or more processors, a first angular orientation of a second louver pivotably coupled to the door of the server; and
further optionally comprising calculating, by the one or more processors, a second angular orientation of the second louver based on the first temperature value and the first noise level; and
further optionally comprising causing, by the one or more processors, the second louver to be modulated to a second angular orientation different from the first angular orientation of the second louver.

15. The method of any one of claims 12 to 14, wherein calculating the second angular orientation of the louver comprises comparing the first temperature value and the first noise level to a stored temperature value and a stored noise level; and/or
further comprising sending, by the one or more processors, an alert in response to a determination that at least one of the first temperature value and a first noise level within the data center exceed at least one of a threshold temperature value and a threshold noise level.
